# EUROPÄISCHE PATENTSCHRIFT

(11) **EP 0 880 795 B1**
(45) Veröffentlichungstag und Bekanntmachung des Hinweises auf die Patenterteilung: **17.10.2001**
(21) Anmeldenummer: 97917221.0
(22) Anmeldetag: 07.02.1997
(51) Int. Cl.: H01J 37/32

(54) **VERFAHREN ZUR STEUERUNG DER LEISTUNGSVERTEILUNG BEI BIPOLAREN NIEDERDRUCK-GLIMMPROZESSEN**
PROCESS FOR CONTROL OF THE ENERGY DISTRIBUTION IN BIPOLAR LOW-PRESSURE GLOW PROCESSES
PROCEDE POUR COMMANDER LA REPARTITION ENERGETIQUE DANS DES PROCESSUS BIPOLAIRES A DECHARGE LUMINEUSE BASSE PRESSION

(30) Priorität: 14.02.1996 DE 19605314
(43) Veröffentlichungstag der Anmeldung: 02.12.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: KOPTE, Torsten, Dr. rer. nat., D-01157 Dresden (DE); WINKLER, Torsten, D-01454 Radeberg (DE); KIRCHHOFF, Volker, Dr. rer. nat., D-01324 Dresden (DE)
(86) Internationale Anmeldenummer: DE9700266
(87) Internationale Veröffentlichungsnummer: WO9730468

(56) Entgegenhaltungen:
- EP-A- 0 347 567
- EP-A- 0 508 359
- WO-A-91/12628
- DE-A- 4 242 633
- DE-C- 4 324 683
- US-A- 4 166 784

## Beschreibung

Die Erfindung betrifft ein Verfahren zur Steuerung der Leistungsverteilung auf die beiden Elektroden bei bipolaren Niederdruck-Glimmprozessen sowohl bei einem asymmetrischen als auch bei einem weitestgehend symmetrischen Aufbau der Prozeßeinrichtung. Das Verfahren findet bei der Plasmabehandlung von Oberflächen, der Abscheidung von Schichten aus Plasmen und der plasmagestützten Oberflächenreinigung Anwendung. Insbesondere ist es geeignet bei der Verwendung von Reaktivgasen zur Abscheidung von Verbindungsschichten. Derartige Prozesse dienen vorzugsweise zur Oberflächenveredelung von Bauteilen, Werkzeugen, Halbzeugen und Fertigteilen in der Optik, im Maschinenbau, in der Verpakkungs-, Glas- und Elektroindustrie.

Es sind eine Vielzahl von Verfahren zur Energieeinspeisung in bipolare Glimmeinrichtungen bekannt. Dabei wird die Energie in Form einer Wechselspannung den beiden Elektroden zugeführt. Aufgrund von nicht vermeidbaren Unterschieden der beiden Elektroden bezüglich Geometrie, Prozeßraumumgebung, Magnetfeldeinfluß, Restgaszusammensetzung, Elektrodenbedeckung, Elektrodenabtrag usw. wird im allgemeinen an den beiden Elektroden nicht die gleiche Leistung umgesetzt. Bei vielen Anwendungen kann dieser Unterschied nicht toleriert werden, so daß eine Leistungssymmetrierung erforderlich ist. Andererseits werden bei verschiedenen Anwendungen, wie z.B. bei der Herstellung spezieller Schichtzusammensetzungen, definierte Unterschiede bezüglich der umgesetzten Leistung an den einzelnen Elektroden und damit der Zerstäubungsrate gefordert.
Es ist bekannt, bipolare Rechteckgeneratoren einzusetzen, um diese Anpassungen einfach durchführen zu können. Bei der Verwendung dieser Technik ist es möglich, die Pulsform im Zusammenhang mit Spannung, Strom, Pulslänge oder Leistung für den positiven und negativen Impuls getrennt einzustellen und gegebenenfalls zu steuern. Ein wesentlicher Nachteil besteht darin, daß die Pulsgeneratoren eine technische Grenze in bezug auf Generatorleistung, Pulsspannung und Pulsfrequenz besitzen. Insbesondere bei höheren Generatorleistungen sind Pulsfrequenzen über 30 kHz nicht mehr realisierbar (S. Schiller et al., A New Era of Pulsed Magnetron Sputtering, Society of Vacuum Coaters, 38th Annual Tech. Conf., proceedings, 293-297).
Es ist weiterhin bekannt, als Stromversorgung für den bipolaren Niederdruck-Glimmprozeß Sinusgeneratoren einzusetzen. Besonders beim Einsatz der bipolaren Glimmeinrichtung zur reaktiven Abscheidung von Oxiden hat die Pulsfrequenz einen großen Einfluß auf die Schichtqualität. Um Schichten mit geringer Defektdichte herstellen zu können, muß in einem Frequenzbereich über 50 kHz gearbeitet werden. Dieser Frequenzbereich ist aber nur mit Sinusgeneratoren erreichbar. Für die Großflächenbeschichtung mit bipolaren Glimmeinrichtungen sind hierbei große Generatorleistungen erforderlich. Für kleine Leistungen wird mit Hilfe einer komplizierten Kondensatorbeschaltung und einer Zusatzelektrode sowie einer zusätzlichen Stromversorgung eine Anpassung eines Sinusgenerators für die reaktive Beschichtung durch Zerstäuben mit bipolarer Glimmeinrichtung erreicht (DE 40 42 287 A1). Der Nachteil dieses Verfahrens besteht darin, daß die Kondensatorbeschaltung genau an die Impedanz der bipolaren Glimmeinrichtung angepaßt sein muß. Die Impedanz der Glimmeinrichtung ist aber stark vom Reaktivgaseinfluß und anderen Prozeßparametern abhängig, so daß diese Anpassung nur in einem engen Arbeitsbereich wirksam werden kann. Eine dynamische Anpassung an den jeweiligen Prozeßzustand ist nicht möglich. Für große Leistungen ist das Verfahren nicht einsetzbar.

Es ist weiterhin bekannt, durch eine Verbindung der beiden Versorgungsleitungen der bipolaren Glimmeinrichtung über eine Gleichrichterdiode und einen Widerstand, die beiden Katoden mit einem frei wählbaren Leistungsverhältnis zu betreiben (DE 41 38 794 A1, DE 42 04 998 A1, EP 0 546 293 A1). Der Nachteil dieses Verfahrens besteht darin, daß das Leistungsverhältnis durch Wahl des Widerstandes nur statisch eingestellt werden kann. Eine Veränderung des Leistungsverhältnisses als Reaktion auf eine Änderung der Prozeßparameter während des Prozesses ist nicht möglich. Ein weiterer Nachteil besteht darin, daß ein Teil der vom Generator zur Verfügung gestellten Energie am Widerstand umgesetzt wird, was zu einer Verringerung des Wirkungsgrades des Gesamtprozesses führt.

Es ist weiterhin bekannt, für große Leistungen in Abhängigkeit vom Prozeßzustand einzelne Halbwellen ganz und/oder teilweise auszublenden und somit für den Glimmprozeß unwirksam zu machen (DE 43 24 683 C1). Dadurch kann die an den einzelnen Elektroden umgesetzte Leistung unabhängig von Generatorleistung und Frequenz in Abhängigkeit vom Prozeßzustand dynamisch angepaßt werden. Ein Nachteil des Verfahrens besteht darin, daß die technische Realisierung einen hohen apparativen Aufwand erfordert. Durch das Ausblenden ganzer Halbwellen kann die Leistungsverteilung auf die beiden Katoden nur in diskreten Stufen verändert werden. Eine kontinuierliche Veränderung der Leistungsverteilung ist durch das teilweise Ausblenden von Halbwellen möglich. Dies erfordert aber schnelle elektrische Schaltvorgänge unter Last, welche nur durch eine komplizierte Leistungselektronik realisierbar sind. Ein weiterer Nachteil ist darin zu sehen, daß die Energie der ausgeblendeten Halbwellen vernichtet werden muß, was den Wirkungsgrad des Gesamtprozesses stark verringern kann.

Es ist weiterhin bekannt, daß beim Betrieb von gepulsten inversen Zerstäubungs-Ätzern bereits mit einer Überlagerung von Gleich- und Wechselspannung gearbeitet wird (S. Schiller et al., Advances in Pulsed Plasma Technology, R. Bakish, Proceedings of the Eight International Conf. on Vacuum Web Coating; 138-151). Dabei ist die Gleichspannungsversorgung mit einem Pol mit Erdpotential und mit dem anderen Pol mit der Wechselspannungsversorgung verbunden. Eine Elektrode der Ätzeinrichtung befindet sich auf Erdpotential, die andere ist mit der Wechselspannungsversorgung verbunden. Dieses Verfahren dient der Steuerung der Dichte der auf dem Substrat auftreffenden Ladungsträger einer bestimmten Art (Ionen oder Elektronen). Eine einfache Übertragung dieses Verfahrens auf eine bipolare Gimmeinrichtung ist nicht möglich, da in diesem Fall beide Elektroden erdfrei sein müssen. Daher würden bei einer direkten Verbindung von Gleich- und Wechselspannungsversorgung an der Gleichspannungsversorgung Wechselspannungsspitzen bis zu einigen kV gegen Erdpotential auftreten. Gegen diese sind die bekannten Gleichspannungsversorgungen nicht geschützt.

Es ist weiterhin bekannt, die Plasmagröße einer Gleichstrom Niederdruck-Glimmentladung zu messen und zu analysieren und damit bei der reaktiven Beschichtung die Steuerung der Schichtzusammensetzung vorzunehmen (US 4,166,784; US 4,407,709). Dabei werden die Intensität der optischen Plasmaemission als Regelgröße und der Reaktivgasfluß oder die Generatorleistung als Stellgröße genutzt Eine Übertragung dieses Verfahrens auf die bipolare Niederdruck-Glimmentladung kann nicht erfolgen, da eine stetige getrennte Steuerung der Leistung an den beiden Elektroden nach den bekannten Verfahren nicht oder nur mit großem technischen Aufwand möglich ist.

Der Erfindung liegt die Aufgabe zugrunde, ein Verfahren zur Steuerung der Leistungsverteilung auf die beiden Elektroden eines bipolaren Niederdruck-Glimmprozesses zu schaffen, welches es mit einfachen technischen Mitteln bei der bipolaren Niederdruck-Glimmentladung ermöglicht, die Aufteilung der Generatorleistung auf die beiden Elektroden statisch und dynamisch zu steuern. Das Verfahren soll in einem großen Frequenzbereich und für hohe Leistungen anwendbar sein. Die Anpassung muß in Abhängigkeit von einem vorgegebenen Sollwert für eine in-situ gemessene Prozeßgröße steuer- und regelbar sein, um eine sehr genaue Einhaltung der Prozeßparameter zu erreichen.

Erfindungsgemäß wird die Aufgabe nach den Merkmalen des Anspruches 1 gelöst. Weitere vorteilhafte Ausgestaltungen zeigen die Ansprüche 2 bis 10.

Ein besonderer Vorteil dieses Verfahrens besteht darin, daß die Aufteilung der Wechselspannungs-Generator-Leistung auf die beiden Elektroden beim bipolaren Niederdruck-Glimmprozeß in einem großen Frequenzbereich sowohl statisch als auch in Abhängigkeit vom Prozeßzustand dynamisch angepaßt werden kann.
Erfindungsgemäß wird der in eine bipolare Glimmeinrichtung eingespeisten Wechseispannung eine Gleichspannung aufgeprägt. Durch eine geeignete bekannte Schaltung wird hierbei die Gleichspannungsversorgung vor der hohen Wechselspannung geschützt. Aufgrund der sehr steilen Strom-Spannungs-Kennlinie einer Glimmentladung kann durch eine relativ kleine Gleichspannung, auch als DC-Offset bezeichnet, eine deutliche Verschiebung der Aufteilung der Wechselspannungs-Leistung auf die beiden Elektroden erreicht werden.
Ein weiterer Vorteil des erfindungsgemäßen Verfahrens besteht darin, daß stets die gesamte bereitgestellte Leistung der Wechselspannungsversorgung auch dem bipolaren Glimmprozeß zugeführt wird; nur ihre Aufteilung auf die beiden Elektroden wird gesteuert. Insbesondere ist das Verfahren geeignet, die Leistungsverteilung beim bipolaren Glimmprozeß zu symmetrieren.
Eine weitere vorteilhafte Ausgestaltung besteht darin, die Gleichspannung durch eine in-situ gemessene Prozeßgröße zu steuern, z.B. die optische Plasmaemission, Beschichtungsrate beim Zerstäuben oder Abtragsrate beim Ätzen.
Das Verfahren ist in Verbindung mit jeder Art von Wechselspannung ausreichend hoher Frequenz - insbesondere sinusförmiger Wechselspannung - anwendbar. Es ist auch für reaktiv geführte Prozesse geeignet.

Anhand von zwei Ausführungsbeispielen wird die Erfindung näher erläutert. In den zugehörigen Zeichnungen zeigen:
- Fig. 1:: eine Einrichtung zum reaktiven Beschichten eines Substrats mit Aluminiumoxid mittels bipolarer Glimmentladung
- Fig. 2:: eine Einrichtung zum Beschichten mittels bipolarer Glimmentladung mit Leistungssymmetrierung

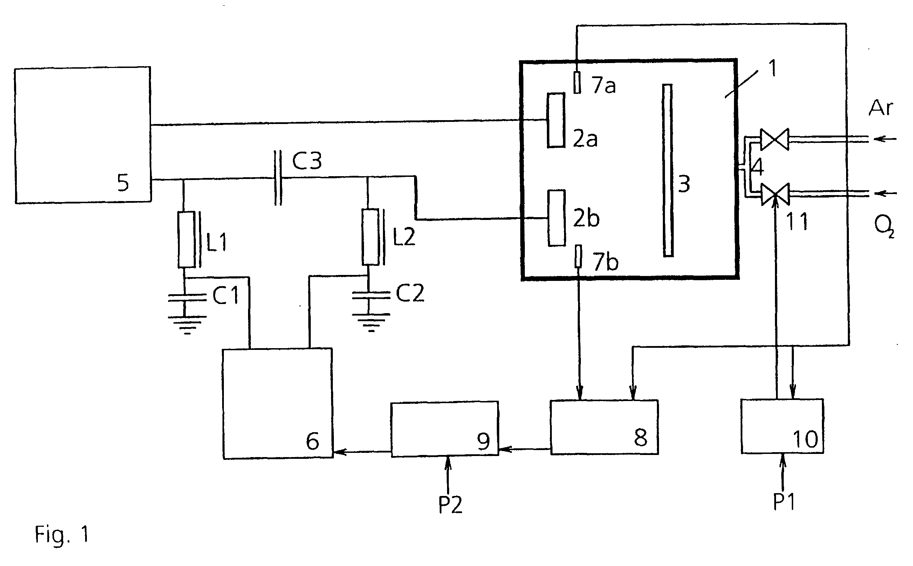

In Fig. 1 befindet sich in einer Vakuumkammer 1 eine bipolare Glimmeinrichtung mit ihren beiden in einem Magnetfeld befindlichen Elektroden bzw. Targets 2a; 2b zum Magnetronzerstäuben. Die Einrichtung ist zum Beschichten von ebenen Substraten 3, das sind Glasscheiben, mit Aluminiumoxid vorgesehen. Die beiden Targets 2a; 2b bestehen aus Aluminium. In die Vakuumkammer 1 wird über den Gaseinlaß 4 ein Argon-Sauerstoffgemisch eingelassen. Der Arbeitsdruck beträgt ca. 0,3 Pa.
Ein Sinusgenerator 5 mit einer Nennleistung von 50 kW arbeitet in einem Frequenzbereich von 20 bis 100 kHz. Die beiden Elektroden 2a; 2b arbeiten wechselweise als Katode bzw. Anode.
Der Sinusspannung wird eine Gleichspannung aufgeprägt, welche eine an sich bekannte Vier-Quadranten-Gleichspannungsversorgung 6 liefert. Diese Gleichspannungsversorgung 6 ist in der Lage, jede beliebige Gleichspannung bereitzustellen. Zugehörige LC-Glieder L1/C1 und L2/C2 sind so dimensioniert, daß die Wechselspannung an der Gleichspannungsversorgung 6 kleiner 10 V eff. ist und die gegen Masse abfließenden Wechselströme kleiner als 500 mA sind. Ein Kondensator C3 ist so dimensioniert, daß der Wechselstrom ohne nennenswerte Verluste über ihn fließen kann. Im Beispiel beträgt die Induktivität von L1 und L2 10mH und die Kapazität von C 1 und C2 2µF und von C3 4µF.
Mittels Sensoren 7a; 7b wird die optische Plasmaemission an den beiden Elektroden 2a; 2b gemessen. Die Meßwerte werden einer bekannten Verarbeitungseinheit 8 zugeführt. In dieser wird der Quotient aus den beiden Meßwerten gebildet, welcher dann als Regelgröße einem bekannten PDI-Regler 9 zugeführt wird. Die Stellgröße des so gebildeten Regelkreises ist die Spannung an der Gleichspannungsversorgung 6. Der Meßwert des Sensors 7a wird außerdem direkt einem zweiten PDI-Regler 10 zugeführt. Dieser steuert den Reaktivgasfluß über ein Gasregelventil 11.
Mit dieser Anordnung kann jedes erforderliche Verhältnis der Leistungen an den beiden Elektroden 2a und 2b im Bereich von 0,5 bis 2 eingestellt werden. Die ohne DC-Offset auftretende Asymmetrie von ca. 20% konnte beseitigt werden.
Die Bestimmung von Arbeitspunkt P1 und P2 für eine optimale Prozeßführung wird auf folgende Weise durchgeführt:
Es werden jeweils kleine Substrate direkt vor den Elektroden 2a; 2b positioniert und stationär beschichtet. Anschließend wird die Transmission der auf den kleinen Substraten abgeschiedenen Schichten gemessen.
Zunächst wird der Arbeitspunkt P1 solange variiert, bis die abgeschiedenen Schichten nur noch schwach - im Bereich von 1 bis 2 % - absorbierend sind. Arbeitspunkt P2 hat dabei den Wert 1.
Im zweiten Schritt wird der Arbeitspunkt P2 solange verändert, bis die an den beiden Elektroden 2a; 2b abgeschiedenen Schichten den gleichen Transmissionswert haben.
Im letzten Schritt wird der Arbeitspunkt P1 nochmals etwas korrigiert, bis die abgeschiedenen Schichten absorptionsfrei sind.
Mit der so gefundenen Einstellung läßt sich Aluminiumoxid absorptionsfrei und mit größtmöglicher Rate abscheiden, da beide Elektroden 2a; 2b im optimalen Arbeitspunkt betrieben werden.

In einem zweiten Beispiel wird anhand einer Einrichtung zum Beschichten mittels bipolarer Glimmentladung eine Leistungssymmetrierung beschrieben.

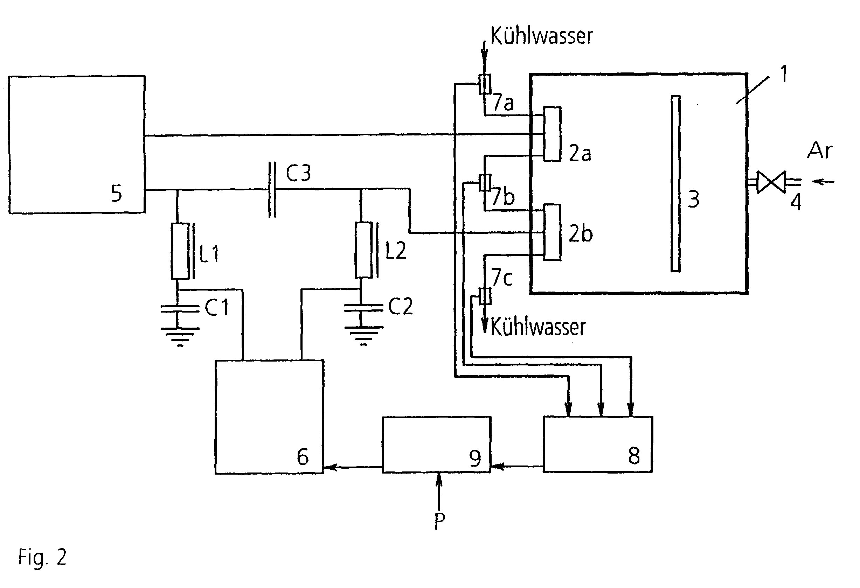

Es befindet sich in Fig. 2 - wie in Fig. 1 dargestellt - in einer Vakuumkammer 1 eine bipolare Glimmeinrichtung 2 mit ihren beiden Elektroden bzw. Targets 2a; 2b zum Magnetronzerstäuben. Die Anordnung dient zum Beschichten von ebenen Substraten 3. In die Vakuumkammer 1 wird über den Gaseinlaß 4 das Arbeitsgas Argon eingelassen. Der Arbeitsdruck beträgt ca. 0,3 Pa.
Ein Sinusgenerator 5 hat eine Nennleistung von 50 kW und arbeitet in einem Frequenzbereich von 20 bis 100 kHz. Die beiden Elektroden 2a; 2b arbeiten wechselweise als Katode bzw. Anode.
Der Sinusspannung wird eine Gleichspannung aufgeprägt, welche eine Vier-Quadranten-Gleichspannungsversorgung 6 liefert. Die LC-Glieder L1/C1 und L2/C2 sind so dimensioniert, daß die Wechselspannung an der Gleichspannungsversorgung 6 kleiner 10 V eff. ist und die gegen Masse abfließenden Wechselströme kleiner als 500 mA sind. Der Kondensator C3 ist so dimensioniert, daß der Wechselstrom ohne nennenswerte Verluste über ihn fließen kann. Im Beispiel beträgt die Induktivität von L1 und L2 10mH und die Kapazität von C1 und C2 2µF und von C3 4µF.
Die beiden Elektroden 2a; 2b der bipolaren Glimmeinrichtung werden nacheinander vom Kühlwasser durchströmt, so daß beide Elektroden 2a; 2b von derselben Kühlwassermenge durchflossen werden. Die Temperaturerhöhung des Kühlwassers an den beiden Elektroden 2a; 2b ist somit ein direktes Maß für die ins Kühlwasser eingebrachte Energie und damit auch für die an den Elektroden umgesetzte Zerstäubungsleistung. Mittels Sensoren 7a; 7b; 7c wird die Kühlwassertemperatur gemessen. Die Meßwerte werden einer bekannten Verarbeitungseinheit 8 zugeführt. Es werden die Temperaturerhöhung des Kühlwassers an den beiden Elektroden 2a; 2b und die Differenz zwischen beiden Elektroden 2a; 2b berechnet. Der Wert der Differenz wird als Regelgröße einem bekannten PDI-Regler 9 zugeführt. Die Stellgröße des so gebildeten Regelkreises ist die Spannung an der Gleichspannungsversorgung 6. Der Arbeitspunkt P für den PDI-Regler 9 ist im Fall der Leistungssymmetrierung gleich Null.
Mit dieser Anordnung werden Asymmetrien in der Leistungsverteilung einer bipolaren Glimmeinrichtung automatisch ausgeregelt.

## Patentansprüche

1. Verfahren zur Steuerung der Leistungsverteilung bei bipolaren Niederdruckglimmprozessen auf zwei in einem Magnetfeld befindlichen Elektroden, die mit den Ausgängen einer Wechselspannungsversorgung verbunden werden, wobei eine Elektrode galvanisch und eine Elektrode über einen Kondensator mit je einem Ausgang der Wechselspannungsversorgung verbunden wird, und die Elektroden mit Wechselspannung der Wechselspannungsversorgung und überlagerter Gleichspannung einer steuerbaren Gleichspannungsversorgung betrieben werden, worin die Gleichspannung mittels einer steuerbaren Vier-Quadranten-Gleichspannungsversorgung, welche wechselspannungsseitig entkoppelt mit einem Pol der Wechselspannungsversorgung und mit dem anderen Pol mit einer Elektrode der bipolaren Glimmeinrichtung verbunden ist, erzeugt wird, und die variable, überlagerte Gleichspannung in Abhängigkeit einer Prozeßgröße der Glimmentladung und der aufzubringenden Beschichtung derart geregelt und/oder eingestellt wird, daß sich ein bestimmtes Verhältnis der Leistungsverteilung zwischen den beiden Elektroden einstellt.

2. Verfahren nach Anspruch 1, **dadurch gekennzeichnet, daß** die elektrischen Entladungsparameter des bipolaren Niederdruck-Glimmprozesses für jede Halbwelle der Wechselspannung einzeln bestimmt werden und in Abhängigkeit von der Differenz zwischen den beiden Halbwellen die Vier-Quadranten-Gleichspannungsversorgung gesteuert wird.

3. Verfahren nach Anspruch 2, **dadurch gekennzeichnet, daß** als Prozeßgröße die Energie pro Halbwelle verwendet wird.

4. Verfahren nach Anspruch 2, **dadurch gekennzeichnet, daß** als Prozeßgröße die mittlere Spannung der einzelnen Halbwellen verwendet wird.

5. Verfahren nach Anspruch 2, **dadurch gekennzeichnet, daß** als Prozeßgröße der mittlere Strom der einzelnen Halbwellen verwendet wird.

6. Verfahren nach Anspruch 1, **dadurch gekennzeichnet, daß** als Maß die in das Kühlwasser der beiden Elektroden eingebrachte Energie einzeln bestimmt wird, und in Abhängigkeit von der Differenz der Meßwerte zwischen den beiden Elektroden die Gleichspannungsversorgung gesteuert wird.

7. Verfahren nach mindestens einem der Ansprüche 1 bis 6, **dadurch gekennzeichnet, daß** die Intensität der optischen Emission des Plasmas für jede Elektrode einzeln gemessen wird und in Abhängigkeit von der Meßgröße die Gleichspannungsversorgung so gesteuert wird, daß die Intensität der optischen Emission des Plasmas an beiden Elektroden gleich ist.

8. Verfahren nach Anspruch 7, **dadurch gekennzeichnet, daß** die Intensität der optischen Emission des Plasmas der ersten Elektrode durch Steuerung der Leistung der Wechselspannungsversorgung konstant gehalten wird und die Intensität der optischen Emission des Plasmas der zweiten Elektrode mittels der Gleichspannungsversorgung so gesteuert wird, daß beide Intensitäten gleich sind.

9. Verfahren nach Anspruch 7 oder 8, **dadurch gekennzeichnet, daß** ein bestimmtes Verhältnis der Intensitäten der optischen Emission des Plasmas der beiden Elektroden eingestellt wird.

10. Verfahren nach Anspruch 9, **dadurch gekennzeichnet, daß** das Verhältnis der Intensitäten der optischen Emission des Plasmas der beiden Elektroden durch Messung bestimmter Eigenschaften der abgeschiedenen Schicht bestimmt wird.

## Claims

1. Method for controlling the power distribution during bipolar low pressure glow processes to two electrodes which are located in a magnetic field and are connected to the outputs of an alternating voltage supply, one electrode being connected galvanically and one electrode being connected via a condenser to an output respectively of the alternating current supply and the electrodes being operated with alternating voltage of the alternating voltage supply and with superimposed direct voltage of a controllable direct voltage supply, wherein the direct voltage is produced by means of a controllable four quadrant direct voltage supply, which is uncoupled on the alternating voltage side and connected to one pole of the alternating voltage supply and by the other pole to an electrode of the bipolar glow device, and the variable superimposed direct voltage is adjusted and/or set dependent on a process variable of the glow discharge and on the coating to be applied in such a manner that a specific ratio of the power distribution between both electrodes occurs.

2. Method according to claim 1, **characterised in that** the electrical discharge parameters of the bipolar low pressure glow process are determined individually for each half-wave of the alternating voltage and, dependent upon the difference between the two half-waves, the four quadrant direct voltage supply is controlled.

3. Method according to claim 2, **characterised in that** the energy per half-wave is used as process variable.

4. Method according to claim 2, **characterised in that** the average voltage of the individual half-waves is used as process variable.

5. Method according to claim 2, **characterised in that** the average current of the individual half-waves is used as process variable.

6. Method according to claim 1, **characterised in that** the energy introduced into the cooling water of both electrodes is determined individually as a measurement and the direct voltage supply is controlled dependent upon the difference of the measured values between both electrodes.

7. Method according to at least one of the claims 1 to 6, **characterised in that** the intensity of the optical emission of the plasma is measured individually for each electrode and the direct voltage supply is controlled dependent upon the measured quantity in such a manner that the intensity of the optical emission of the plasma is the same at both electrodes.

8. Method according to claim 7, **characterised in that** the intensity of the optical emission of the plasma of the first electrode is maintained constant by controlling the output of the alternating voltage supply and the intensity of the optical emission of the plasma of the second electrode is controlled by means of the direct voltage supply in such a manner that both intensities are the same.

9. Method according to claim 7 or 8, **characterised in that** a specific ratio of intensities of the optical emission of the plasma of both electrodes is set.

10. Method according to claim 9, **characterised in that** the ratio of the intensities of the optical emission of the plasma of both electrodes is determined by measuring specific properties of the deposited layer.

## Revendications

1. Procédé de commande de la répartition de puissance dans un procédé de décharge lumineuse bipolaire basse pression entre deux électrodes placées dans un champ magnétique et qui sont reliées aux sorties d'une alimentation en tension alternative, une électrode étant reliée galvaniquement à une sortie de l'alimentation en tension alternative et l'autre étant reliée par l'intermédiaire d'un condensateur, les électrodes recevant une tension alternative fournie par l'alimentation en tension alternative ainsi qu'une tension continue combinée fournie par une alimentation en tension alternative, commandée, dans laquelle la tension continue est générée par une alimentation en tension continue à quatre quadrants, commandée, qui est reliée de manière découplée, du côté de la tension alternative par un pôle de la tension alternative et, par l'autre pôle, à une électrode de l'installation à décharge lumineuse bipolaire, et la tension continue variable, combinée est régulée en fonction d'une grandeur du processus de décharge lumineuse et du revêtement appliqué, pour être régulée et/ou réglée de manière à avoir un rapport défini des puissances entre les deux électrodes.

2. Procédé selon la revendication 1,
**caractérisé en ce que**
les paramètres de décharge électrique du processus de décharge lumineuse basse pression se définissent séparément pour chaque demi-onde de la tension alternative et sont commandés en fonction de la différence entre les deux demi-ondes de l'alimentation en tension continue à quatre quadrants.

3. Procédé selon la revendication 2,
**caractérisé en ce que**
la grandeur utilisée du procédé est l'énergie par demi-ondes.

4. Procédé selon la revendication 2,
**caractérisé en ce que**
la grandeur utilisée du procédé est la tension moyenne des différentes demi-ondes.

5. Procédé selon la revendication 2,
**caractérisé en ce que**
la grandeur utilisée du procédé est le courant moyen des différentes demi-ondes.

6. Procédé selon la revendication 1,
**caractérisé en ce que**
comme mesure, on détermine séparément l'énergie fournie à l'eau de refroidissement par les deux électrodes et, en fonction de la différence des valeurs de mesure entre les deux électrodes, on commande l'alimentation en tension continue.

7. Procédé selon au moins l'une des revendications 1 à 6,
**caractérisé en ce qu'**
on mesure l'intensité de l'émission optique du plasma pour chaque électrode et, en fonction de la grandeur de mesure, on commande l'alimentation en tension continue pour que l'intensité de l'émission optique du plasma sur les deux électrodes soit la même.

8. Procédé selon la revendication 7,
**caractérisé en ce qu'**
on maintient constante l'intensité de l'émission optique du plasma de la première électrode en commandant la puissance de l'alimentation en tension continue, et on commande l'intensité de l'émission optique du plasma de la seconde électrode par l'alimentation en tension continue pour que les deux intensités soient les mêmes.

9. Procédé selon la revendication 7 ou 8,
**caractérisé en ce qu'**
on règle un certain rapport des intensités de l'émission optique du plasma des deux électrodes.

10. Procédé selon la revendication 9,
**caractérisé en ce qu'**
on détermine le rapport des intensités de l'émission optique du plasma des deux électrodes par la mesure de certaines propriétés de la couche déposée.
